# FASCICULE DE BREVET EUROPEEN

(11) **EP 4 111 151 B1**
(45) Date de publication et mention de la délivrance du brevet: **10.12.2025**
(21) Numéro de dépôt: 21710555.0
(22) Date de dépôt: 24.02.2021
(51) Int. Cl.: G01L 1/18, G06F 3/041, G06F 3/044, G06F 3/045, G01D 21/02, B60N 2/75, G01L 1/14

(54) **BOÎTIER DE COMMANDE POUR VÉHICULE AUTOMOBILE**
STEUERUNGSEINHEIT FÜR EIN KRAFTFAHRZEUG
CONTROL UNIT FOR A MOTOR VEHICLE

(30) Priorité: 28.02.2020 FR 2002055
(43) Date de publication de la demande: 04.01.2023
(73) Titulaire: NOVARES France, 78140 Vélizy-Villacoublay (FR); Nanomade Lab, 31400 Toulouse (FR)
(72) Inventeur: CAZES, Christophe, 78000 VERSAILLES (FR); LELIEVRE, François, 92160 ANTHONY (FR); SEVERAC, Fabrice, 31300 TOULOUSE (FR); DUFOUR, Nicolas, 31290 VALLEGUE (FR)
(74) Mandataire: Germain Maureau
(86) Numéro de dépôt international: PCT/FR2021/050324
(87) Numéro de publication internationale: WO 2021/170957

(56) Documents cités:
- EP-B1- 1 978 535
- US-A1- 2015 268 692
- US-A1- 2017 357 344
- ANONYMOUS: "Unflattening Touch Screen Buttons | SciTe Daily", 24 November 2009 (2009-11-24), pages 1 - 8, XP093098853, Retrieved from the Internet <URL:https://scitedaily.wordpress.com/2009/11/24/unflattening-the-touch-screen/> [retrieved on 20231107]

## Description

La présente invention concerne un boîtier de commande pour véhicule automobile destiné à commander plusieurs fonctions dudit véhicule.

L'habitacle d'un véhicule automobile constitue pour des utilisateurs - conducteur et éventuels passagers - un lieu de vie et d'interaction avec des commandes qui permettent de contrôler des fonctions du véhicule ; ces fonctions sont de nature très diverses et peuvent concerner notamment l'ouverture et la fermeture des portes du véhicule, l'orientation des rétroviseurs latéraux, ainsi que l'ouverture et la fermeture des vitres équipant les portes latérales du véhicule. Les commandes que l'on trouve typiquement à l'intérieur d'un véhicule et qui constituent l'interface pour contrôler les fonctions d'un véhicule sont notamment du type :
- boutons poussoirs pour, par exemple, commander le verrouillage d'un véhicule,
- boutons rotatifs pour, par exemple, commander le réglage de température du système de climatisation ;
- boutons basculants pour, par exemple, commander le mécanisme d'ouverture/fermeture des vitres
- gâchette pour, par exemple, commander le mécanisme d'ouverture des portes
- curseurs pour, par exemple, commander le réglage de température du système de climatisation

L'habitacle de véhicule se trouve donc équipé d'une multitude d'organes de commandes. Ces organes de commandes - boutons, curseurs...- sont de type mécanique ou électromécanique. A ce titre, ces organes de commande sont, d'une part, relativement couteux et d'autre part, présentent des contraintes d'implantation importantes dans l'habitacle du véhicule puisqu'ils ne peuvent être positionnés qu'à des emplacements qui permettent d'accueillir leurs mécanismes. Cette dernière contrainte réduit donc fortement la liberté de conception de l'habitacle puisque l'implantation de ces organes est dictée non pas selon des considérations ergonomiques mais selon des contraintes mécaniques qui peuvent être en contradiction avec les considérations d'ergonomie.

Dans ce contexte technique, il a été proposé dans le document EP 1 978 535 B1 d'équiper un véhicule automobile d'un boîtier de commande regroupant plusieurs organes de commande. Ce boîtier de commande est avantageusement installé dans un accoudoir de la portière d'un véhicule. Toutefois, même si le boîtier de commande décrit dans cet art antérieur permet de réduire le nombre d'organes de commande, son fonctionnement nécessite, de la part de l'utilisateur, d'effectuer une suite d'opérations complexes combinant à la fois des appuis longs et des appuis courts avec ses doigts pour pouvoir exécuter une fonction particulière. Cette contrainte résulte de l'utilisation de capteurs capacitifs au sein du boîtier de commande qui permettent uniquement de détecter la durée d'un contact sur les organes de commande et pas l'intensité de ce contact.

US2017/357344 divulgue un écran tactile.

Un des buts de l'invention est donc de proposer un boîtier de commande pour véhicule automobile ne présentant pas les inconvénients de l'art antérieur décrit précédemment.

A cet effet, l'invention concerne un boîtier de commande pour véhicule automobile selon la revendication 1, comprenant :
- une coque externe munie de plusieurs zones de commande, chacune des zones de commande étant affectée à une fonction spécifique du véhicule automobile,
- une plaque de circuit imprimé supportant une pluralité de capteurs élémentaires configurés pour générer un signal électrique en réponse à une action telle qu'un mouvement d'approche, un contact ou une pression exercée par un utilisateur au moyen de ses doigts sur au moins l'une des zones de commande, lesdits capteurs élémentaires étant reliés à une Unité de Commande Electronique (ECU), le signal électrique généré par les capteurs élémentaires étant transmis à l'ECU pour y être analysé et converti en une commande d'une fonction du véhicule, dans lequel chacun des capteurs élémentaires comprend au moins un substrat isolant sur lequel sont déposées des pistes conductrices formant un capteur capacitif et une assemblée de nanoparticules conductrices ou semi-conductrices en suspension colloïdale dans un ligand électriquement isolant, ladite assemblée formant un capteur de force.

Ainsi configuré, le boîtier de commande de l'invention permettra d'effectuer un grand nombre d'opérations au sein d'un véhicule automobile en combinant à la fois des capteurs capacitifs, permettant une détection à distance ou au contact, et des capteurs de force, permettant de mesurer l'intensité d'un contact sur une des zones de commande du boîtier de commande.

Selon d'autres caractéristiques, le boîtier de l'invention pourra comporter une ou plusieurs des caractéristiques optionnelles suivantes considérées seules ou en combinaison ;
- au moins l'une des zones de commande forme une protubérance sur une surface supérieure de la coque externe sur laquelle un doigt d'un utilisateur peut s'appuyer, ladite au moins une zone de commande étant disposée de manière contiguë à l'un des capteurs élémentaires de telle sorte que l'appui sur ladite au moins une zone de commande génère une déformation dudit capteur élémentaire qui peut être détectée par le capteur de force dudit capteur élémentaire.
- le boîtier de commande comprend de plus une pluralité de dispositifs d'éclairage, chacun desdits dispositifs d'éclairage étant aptes à émettre un faisceau de lumière en direction de la coque externe au niveau d'une zone de commande.
- les dispositifs d'éclairage sont fixés sur la plaque de circuit imprimé et sont disposés sous les capteurs élémentaires.
- chaque dispositif d'éclairage est constitué d'une diode électroluminescente et/ou d'un guide de lumière.
- les dispositifs d'éclairage sont commandés par l'ECU, l'ECU pouvant faire varier le faisceau de lumière émis par les dispositifs d'éclairage en fonction des signaux électriques transmis par les capteurs élémentaires.
- les zones de commande sont au moins de deux types, à savoir des premières zones de commande, dites zones de sélection, lesquelles sont destinées à sélectionner un élément spécifique du véhicule, et des deuxièmes zones de commande, dites zones de réglage, lesquelles sont destinées à régler soit la position, soit l'état d'un élément spécifique du véhicule préalablement sélectionné par l'une desdites zones de sélection.
- le boîtier de commande comprend quatre zones de sélection, dites zones de sélection de vitre, affectées respectivement à la sélection d'une vitre du véhicule, respectivement une vitre avant gauche, une vitre avant droite, une vitre arrière gauche et une vitre arrière droite, et deux zones de réglage, dites zones de réglage de vitre, permettant de déplacer la vitre sélectionnée par lesdites zones de sélection de vitre respectivement vers le bas et vers le haut.
- des capteurs élémentaires disposés sous les zones de sélection de vitre sont configurés pour détecter le contact d'un doigt d'un utilisateur sur lesdites zones de sélection de vitre au moyen de leur capteur capacitif et en ce que des capteurs élémentaires disposés sous les zones de réglage de vitre sont configurés pour détecter la pression d'un doigt d'un utilisateur sur lesdites zones de réglage de vitre au moyen de leur capteur de force.
- les capteurs élémentaires sont imprimés sur un film inséré entre la coque externe et les dispositifs d'éclairage présents sur la face supérieure de la plaque de circuit imprimé.
- le boîtier de commande comprend deux zones de sélection, dites zones de sélection de rétroviseur, affectées respectivement à la sélection d'un rétroviseur du véhicule, respectivement un rétroviseur latéral gauche et un rétroviseur latéral droit, et quatre zones de réglage, dites zones de réglage de rétroviseur, permettant de déplacer le rétroviseur sélectionné par lesdites zones de sélection de rétroviseur respectivement vers la gauche, vers la droite, vers le bas et vers le haut.
- des capteurs élémentaires disposés sous les zones de sélection de rétroviseur et sous les zones de réglage de rétroviseur sont configurés pour détecter le contact d'un doigt d'un utilisateur respectivement sur lesdites zones de sélection de rétroviseur et sur lesdites zones de réglage de rétroviseur au moyen de leur capteur capacitif.
- le boîtier de commande comprend deux zones de commande, dites zones de verrouillage/déverrouillage, permettant respectivement de verrouiller et de déverrouiller les portes du véhicule.
- le boîtier de commande comprend au moins un capteur élémentaire configuré pour détecter la présence d'un doigt d'un utilisateur à proximité du boîtier de commande, l'ECU étant apte, en réponse au signal transmis par ledit au moins un capteur élémentaire, de faire passer au moins certains des capteurs élémentaires d'un mode désactivé, dans lequel ils ne sont pas sensibles aux actions d'un utilisateur, à un mode activé, dans lequel ils sont sensibles aux actions d'un utilisateur.
- le boîtier de commande comprend au moins un capteur élémentaire configuré pour détecter le contact d'un doigt d'un utilisateur sur une zone de commande spécifique du boîtier de commande au moyen de son capteur capacitif, l'ECU étant apte, en réponse au signal transmis par ledit au moins un capteur élémentaire, de faire passer certains des capteurs élémentaires d'un mode partiellement activé, dans lequel ils peuvent uniquement détecter le contact d'un doigt d'un utilisateur au moyen de leur capteur capacitif, à un mode désactivé, dans lequel ils ne sont pas sensibles aux actions d'un utilisateur, et certains autres capteurs élémentaires d'un mode désactivé, dans lequel ils ne sont pas sensibles aux actions d'un utilisateur, à un mode partiellement activé, dans lequel ils peuvent uniquement détecter la pression d'un doigt d'un utilisateur au moyen de leur capteur de force.

L'invention concerne également un véhicule automobile comprenant un boîtier de commande tel que défini ci-dessus.

### Brève description des dessins

L'invention est exposée ci-après selon plusieurs modes de réalisation préférés, nullement limitatifs, et en référence aux Figures 1 à 12 dans lesquelles :
La Figure 1 est une vue en perspective éclatée d'un boîtier de commande selon l'invention ;
La Figure 2 est une vue en coupe transversale du boîtier de commande de la Figure 1 ;
La Figure 3 est une vue de face du boîtier de commande de la Figure 1 ;
La Figure 4 est une vue de dessus, selon un premier mode de réalisation, d'un capteur élémentaire utilisable dans le cadre de l'invention ;
La Figure 5 est une vue en coupe selon la ligne de coupe AA du capteur de la Figure 4;
La Figure 6 est une vue similaire à la Figure 5 mais selon un deuxième mode de réalisation d'un capteur élémentaire utilisable dans le cadre de l'invention ;
La Figure 7A est une vue en coupe d'un capteur élémentaire selon un autre mode de réalisation lors d'une détection de proximité ;
La Figure 7B est une vue similaire à la Figure 7A lors d'une détection d'un toucher ;
La Figure 7C représente l'évolution temporelle du signal issu du capteur de force formé par le capteur élémentaire des Figures 7A et 7B ;
La Figure 7D représente l'évolution temporelle du signal issu du capteur capacitif formé par le capteur élémentaire des Figures 7A et 7B ;
La Figure 8 représente selon une vue de dessus en éclaté un exemple de réalisation d'une surface tactile combinant une pluralité de capteurs élémentaires utilisables dans le cadre de l'invention ;
La Figure 9 montre l'organigramme d'un exemple de procédé mettant en œuvre un capteur élémentaire utilisable dans le cadre de l'invention ;
La Figure 10 est un exemple d'organigramme d'un procédé mettant en œuvre une surface tactile intégrant un capteur élémentaire utilisable dans le cadre de l'invention.
La Figure 11 montre la variation de la tension délivrée en fonction du temps par un capteur de force mettant en œuvre une assemblée de nanoparticules dont la conductivité varie selon la force appliquée audit capteur;
La Figure 12 montre une courbe de déplacement d'une vitre d'un véhicule en réponse à une pression exercée sur un capteur élémentaire utilisable dans le cadre de l'invention.

Les dessins sont des représentations de principe et ne sont pas représentatifs de l'échelle des différents éléments qu'ils représentent.

### Description des modes de réalisation

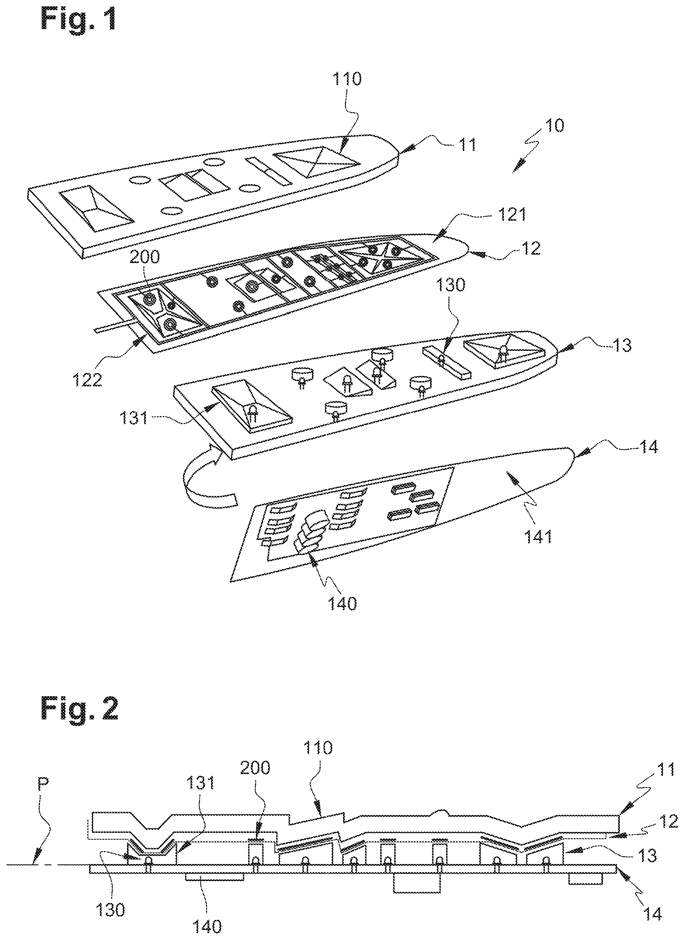

En référence aux Figures 1 à 3, il est représenté un mode de réalisation d'un boîtier de commande selon l'invention.

Dans ce mode de réalisation, le boîtier de commande 10 comprend :
- une coque externe 11 munie de plusieurs zones de commande 110, chacune des zones de commande 110 étant affectée à une fonction spécifique du véhicule automobile,
- une feuille 12 sensible au toucher, supportant une pluralité de capteurs élémentaires 200, ladite feuille 12 étant disposée sous la coque externe 11 de telle manière que chacun des capteurs élémentaires 200 soit contigu à l'une des zones de commande 110,
- un élément intercalaire 13 destiné à produire de la lumière en direction de la coque externe, et
- une plaque 14 de circuit imprimé supportant, sur sa face supérieure, l'élément intercalaire 13 et la feuille 12, et, sur sa face inférieure, des composants électroniques 140 formant une Unité de Commande Electronique (ECU).

Ce boîtier de commande 10 pourra notamment servir pour l'ouverture et la fermeture des vitres latérales, le verrouillage et le déverrouillage des portes, ainsi que pour l'orientation des rétroviseurs latéraux. Il pourra par exemple être intégré dans l'accoudoir du conducteur de manière à être facilement actionnable par ce dernier.

La coque externe 11 sera avantageusement formée dans une matière thermoplastique. Comme illustré sur la Figure 2, les zones de commande 110 définissent des creux et/ou des reliefs à la surface externe supérieure de la coque externe 11, lesdits creux et/ou reliefs étant dimensionnés pour recevoir le doigt d'un utilisateur.

La feuille 12 disposée sous la coque externe 11 est constituée d'un support isolant 121 sur lequel des pistes conductrices 122 sont imprimées, les pistes conductrices 122 étant reliées électriquement aux capteurs élémentaires 200 et à l'ECU.

L'élément intercalaire 13 comprend une pluralité de diodes électroluminescentes 130 et d'une pluralité de guides de lumière 131. Chaque diode électroluminescente 130 est avantageusement alignée, dans une direction perpendiculaire au plan P défini par la plaque 14, avec une des zones de commande 110 de la coque externe 11 et avec l'un des guides de lumière 131. Les diodes électroluminescentes 130 sont par ailleurs connectées électriquement à l'ECU de telle sorte que l'ECU pourra commander l'activation ou la désactivation desdites diodes électroluminescentes 130 en fonction de la zone de commande 110 activée par l'utilisateur. Comme illustré sur la Figure 2, les guides de lumière 131 possèdent avantageusement un profil en relief sensiblement complémentaire à celui des zones de commande 110 de manière à faciliter le montage du boîtier de commande 10.

La plaque 14 de circuit imprimé est notamment constituée d'un support 141 sur lequel sont fixés les composants électroniques 140. Ce support 141 pourra être formé d'un matériau thermoplastique rigide.

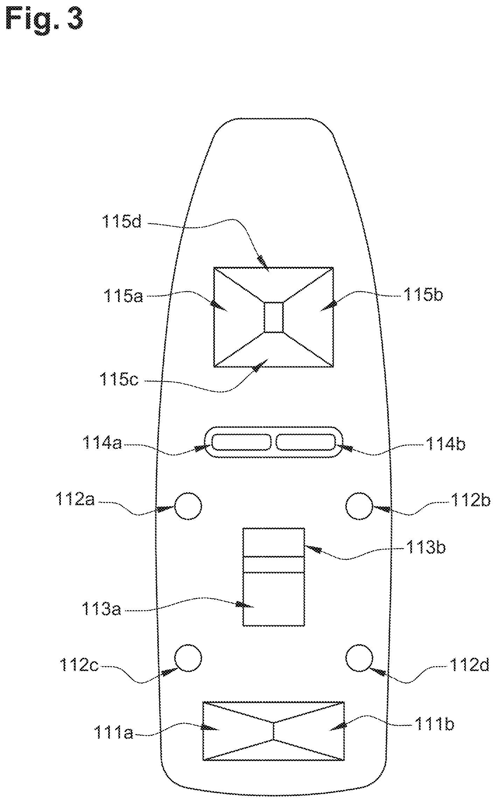

La Figure 3 représente la répartition des zones de commande 110 dans la coque externe 11. En vue de faciliter l'utilisation du boîtier de commande 10, chaque zone de commande 110 possède avantageusement une forme spécifique différente de celle des autres zones de commande 110, permettant ainsi à un utilisateur de facilement l'identifier au toucher, sans avoir besoin de regarder le boîtier de commande 10. Par ailleurs, en vue d'optimiser l'ergonomie du boîtier de commande 10, les zones de commande 110 ont été disposées de manière à être facilement et rapidement actionnable par les doigts de l'utilisateur. Ainsi, en déplaçant ses doigts dans une partie basse du boîtier de commande 10, l'utilisateur pourra accéder à deux zones de commande 111a, 111b disposées côte à côte dans le sens de la largeur, chacune des zones de commande 111a, 111b possédant une forme sensiblement trapézoïdale, les zones de commande 111a, 111b étant inclinées par rapport au plan P et formant un creux à la surface de la coque externe 11. En déplaçant ses doigts dans une partie médiane du boîtier de commande 10, l'utilisateur pourra accéder à quatre zones de commande 112a, 112b, 112c, 112d en forme de disque, les zones de commande 112a-112d étant disposées à la surface de la coque externe 11 de manière à définir ensemble un motif en forme de carré. Les zones de commande 112a-112d pourront simplement affleurer à la surface de la coque externe 11. Deux zones de commande 113a, 113b contiguës dans le sens de la longueur sont en outre positionnées de manière à être à l'intérieur du carré défini par les zones de commande 112a-112d. Comme illustré sur les Figures 1 et 2, chacune des zones de commande 113a, 113b possède une forme rectangulaire et forme un creux à la surface de la coque externe 11. La partie médiane du boîtier de commande 10 loge également deux zones de commande 114a, 114b de forme oblongue et disposée côte à côte dans le sens de la largeur, les zones de commande 114a, 114b formant une partie en relief à la surface de la coque externe 11. Finalement, en déplaçant ses doigts dans une partie haute du boîtier de commande 10, l'utilisateur pourra accéder à quatre zones de commande 115a, 115b, 115c, 115d en forme de trapèze, les zones de commande 115a-115d étant inclinées par rapport au plan P et formant un creux à la surface de la coque externe 11. Les zones de commande 112a-112d sont disposées à la surface de la coque externe 11 de manière à définir ensemble un motif en forme de pyramide.

Chaque zone de commande est affectée à l'avance à une ou plusieurs fonctions spécifiques, ladite ou lesdites fonctions étant réalisées dès que l'utilisateur actionne la zone de commande soit en la touchant avec son doigt, soit en étant suffisamment proche de cette zone de commande pour produire une modification de la capacité électrostatique des capteurs élémentaires 200, comme expliqué en détail dans les paragraphes suivants. Ainsi, chacun des capteurs élémentaires 200 comprendra de manière avantageuse au moins un substrat isolant sur lequel sont déposées des pistes conductrices formant un capteur capacitif et une assemblée de nanoparticules conductrices ou semi-conductrices en suspension colloïdale dans un ligand électriquement isolant, ladite assemblée formant un capteur de force. Une telle configuration avantageuse sera notamment décrite en détail dans les paragraphes suivants.

Les zones de commande peuvent être classifiées en au moins deux types. Un premier type regroupe les zones, dites de sélection, qui sont destinées à sélectionner un élément spécifique du véhicule, et un deuxième type regroupe les zones, dites de réglage, qui sont destinées à régler soit la position, soit l'état d'un élément spécifique du véhicule préalablement sélectionné par l'une des zones de sélection.

Ainsi, dans le mode de réalisation représenté sur la Figure 3, le boîtier de commande 10 comprend notamment quatre zones de sélection, à savoir les quatre zones de commande 112a-112d. Les zones de commande 112a-112d pourront par exemple être affectées spécifiquement à la sélection d'une vitre du véhicule, respectivement une vitre avant gauche pour la zone de commande 112a, une vitre avant droite pour la zone de commande 112b, une vitre arrière gauche pour la zone de commande 112c, et une vitre arrière droite pour la zone de commande 112d. Ces zones de sélection 112a-112d, dites zones de sélection de vitre, devront d'abord être activées par l'utilisateur de manière à choisir la vitre du véhicule que l'utilisateur souhaite monter ou descendre. Une fois ce choix effectué, l'utilisateur devra actionner l'une ou l'autre des zones de commande 113a, 113b, dites zones de réglage de vitre, de manière à déplacer la vitre sélectionnée par lesdites zones de sélection de vitre 112a-112d respectivement vers le bas et vers le haut. A cet effet, les capteurs élémentaires 200 disposés directement sous les zones de sélection de vitre 112a-112d seront avantageusement configurés pour détecter le contact d'un doigt d'un utilisateur sur lesdites zones de sélection de vitre 112a-112d au moyen de leur capteur capacitif. Une fois ce contact détecté, l'ECU pourra désactiver l'ensemble des zones de commande 110 du boîtier de commande 10, mises à part celles correspondant aux zones de réglage de vitre, à savoir les zones de commande 113a et 113b. L'utilisateur pourra ensuite agir avec son doigt sur l'une desdites zones de réglage de vitre 113a, 113b de manière à descendre ou monter la vitre préalablement sélectionnée par les zones de sélection de vitre 112a-112d. A cet effet, les capteurs élémentaires 200 disposés directement sous les zones de réglage de vitre 113a, 113b seront avantageusement configurés pour détecter la pression d'un doigt d'un utilisateur sur lesdites zones de réglage de vitre 113a, 113b au moyen de leur capteur de force.

Le boîtier de commande 10 représenté sur la Figure 3 comprend également deux autres zones de sélection, à savoir les zones de commande 114a et 114b, qui pourront être affectées respectivement à la sélection d'un rétroviseur du véhicule, respectivement un rétroviseur latéral gauche pour la zone de commande 114a et un rétroviseur latéral droit pour la zone de commande 114b. Ces zones de sélection 114a, 114b, dites zones de sélection de rétroviseur, devront d'abord être activées par l'utilisateur de manière à choisir le rétroviseur du véhicule que l'utilisateur souhaite déplacer. Une fois ce choix effectué, l'utilisateur devra actionner l'une ou l'autre des zones de commande 115a-115d, dites zones de réglage de rétroviseur, de manière à déplacer le rétroviseur sélectionné par lesdites zones de sélection de rétroviseur 114a, 114b vers la gauche au moyen de la zone 115a, vers la droite au moyen de la zone 115b, vers le bas au moyen de la zone 115c et vers le haut au moyen de la zone 115d. A cet effet, les capteurs élémentaires 200 disposés directement sous les zones de sélection de rétroviseur 114a, 114b seront avantageusement configurés pour détecter le contact d'un doigt d'un utilisateur sur lesdites zones de sélection de rétroviseur 114a, 114b au moyen de leur capteur capacitif. Une fois ce contact détecté, l'ECU pourra désactiver l'ensemble des zones de commande 110 du boîtier de commande 10, mises à part celles correspondant aux zones de réglage de rétroviseur, à savoir les zones de commande 115a-115d. L'utilisateur pourra ensuite agir avec son doigt sur l'une desdites zones de réglage de rétroviseur 115a-115d de manière à déplacer le rétroviseur préalablement sélectionné par les zones de sélection de rétroviseur 114a-114b, soit vers la gauche, soit vers la droite, soit vers le bas, soit vers le haut. A cet effet, les capteurs élémentaires 200 disposés directement sous les zones de réglage de rétroviseur 115a-115d seront avantageusement configurés pour détecter le contact d'un doigt d'un utilisateur sur lesdites zones de réglage de rétroviseur 115a-115d au moyen de leur capteur capacitif.

Le boîtier de commande 10 représenté sur la Figure 3 comprend par ailleurs deux zones de commande 111a et 111b, dites zones de verrouillage/déverrouillage, permettant respectivement de verrouiller et de déverrouiller les portes du véhicule. A cet effet, les capteurs élémentaires 200 disposés directement sous les zones de verrouillage/déverrouillage 111a, 111b seront avantageusement configurés pour détecter le contact d'un doigt d'un utilisateur sur lesdites zones de verrouillage/déverrouillage au moyen de leur capteur capacitif.

D'une manière générale, le boitier de commande 10 de l'invention pourra comprendre un nombre plus important ou moins important de zones de commande 110 que celui représenté sur la Figure 3. En outre, la répartition, la forme des zones de commande 110 et leurs fonctions affectées pourront différer de celles décrites précédemment.

Toutes les variantes de réalisation possibles du boîtier de commande 10 de l'invention fonctionneront de préférence sur le principe d'une activation/désactivation sélective de certaines zones de commande 110 par l'ECU en fonction des signaux reçus par l'ECU de la part des capteurs élémentaires 200. La ou les zones de commande 110 activées par l'ECU pourront être avantageusement rétroéclairées au moyen de la ou des diodes électroluminescentes 130 et des guides de lumière 131 associés qui sont situés directement sous les zones de commande 110, permettant ainsi à l'utilisateur de savoir quelle(s) zone(s) de commande 110 a été effectivement activée(s) par l'ECU.

Le boîtier de commande 10 de l'invention comprendra de préférence au moins un capteur élémentaire 200 spécifique configuré pour détecter la présence d'un doigt d'un utilisateur à proximité du boîtier de commande, l'ECU étant apte, en réponse au signal transmis par ledit au moins un capteur élémentaire 200 spécifique, de faire passer au moins certains des capteurs élémentaires 200 d'un mode désactivé, dans lequel ils ne sont pas sensibles aux actions d'un utilisateur, à un mode activé, dans lequel ils sont sensibles aux actions d'un utilisateur. Dans une variante possible de l'invention, cette détection se fera au moyen du capteur capacitif dudit au moins un capteur élémentaire 200 spécifique. Dans une autre variante possible de l'invention, l'ensemble des capteurs élémentaires 200 du boîtier de commande 10, mis à part le capteur élémentaire spécifique, pourront être initialement dans un mode désactivé, dans lequel ils ne sont pas sensibles aux actions d'un utilisateur, et, suite à l'activation du capteur élémentaire spécifique, l'ECU pourra faire passer certains des capteurs élémentaires 200 du boîtier de commande 10 de ce mode désactivé vers un mode totalement activé, dans lequel ils sont sensibles aux actions d'un utilisateur à la fois à distance ou au contact, ou partiellement activé, dans lequel ils sont sensibles uniquement au contact de l'utilisateur.

De manière complémentaire, le boîtier de commande 10 pourra également comprendre au moins un capteur élémentaire 200 spécifique configuré pour détecter le contact d'un doigt d'un utilisateur sur une zone de commande 110 spécifique du boîtier de commande au moyen de son capteur capacitif, l'ECU étant apte, en réponse au signal transmis par ledit au moins un capteur élémentaire 200 spécifique, de faire passer certains des capteurs élémentaires 200 d'un mode partiellement activé, dans lequel ils peuvent uniquement détecter le contact d'un doigt d'un utilisateur au moyen de leur capteur capacitif, à un mode désactivé, dans lequel ils ne sont pas sensibles aux actions d'un utilisateur, et certains autres capteurs élémentaires 200 d'un mode désactivé, dans lequel ils ne sont pas sensibles aux actions d'un utilisateur, à un mode partiellement activé, dans lequel ils peuvent uniquement détecter la pression d'un doigt d'un utilisateur au moyen de leur capteur de force.

Ainsi, dans le mode de réalisation particulier représenté sur la Figure 3, les zones de sélection de vitre 112a-112d et les zones de sélection de rétroviseur 114a, 114b pourront se trouver au départ dans un mode partiellement activé, dans lequel ils seront susceptibles de détecter le contact d'un doigt d'un utilisateur au moyen de leur capteur capacitif 221, 222, tandis que les zones de réglage de vitre 113a, 113b et les zones de réglage de rétroviseur 115a-115d seront initialement désactivées. De ce fait, lorsque l'utilisateur activera l'une des zones de sélection avec son doigt, l'ECU produira, en réponse au signal reçu de la part du capteur élémentaire 200 correspondant à la zone pressée par l'utilisateur, une désactivation de l'ensemble des zones de sélection 112a-112d et 114a, 114b et une activation partielle des zones de réglage 113a, 113b, dans le cas où la zone pressée par l'utilisateur est l'une des zones 112a-112d, ou des zones de réglage 115a-115d, dans le cas où la zone pressée par l'utilisateur est l'une des zones 114a, 114b. Dans ce mode partiellement activé, les zones de réglage de vitre 113a, 113b seront uniquement sensibles à la pression exercée par le doigt de l'utilisateur, la pression pouvant être mesurée au moyen des capteurs de force 230 des capteurs élémentaires 200 qui sont positionnés juste en-dessous des zones de réglage de vitre 113a, 113b, et les zones de réglage de rétroviseur 115a-115d seront uniquement sensibles au contact d'un doigt de l'utilisateur, ce contact pouvant être détecté au moyen des capteurs capacitifs 221, 222 des capteurs élémentaires 200 qui sont positionnés juste en-dessous des zones de réglage de rétroviseur 115a-115d. La pression ou le contact détecté par les capteurs de force 230 ou les capteurs capacitifs 221, 222 sera ensuite communiqué à l'ECU sous forme de signal électrique, l'ECU étant susceptible de contrôler le déplacement de la vitre ou du rétroviseur préalablement sélectionné par l'utilisateur au moyen des zones de sélection en fonction des signaux électriques reçus desdits capteurs de force ou desdits capteurs capacitifs. Ainsi, une pression plus ou moins importante sur les zones de réglage de vitre 113a, 113b produira ainsi un déplacement plus ou moins important de la vitre.

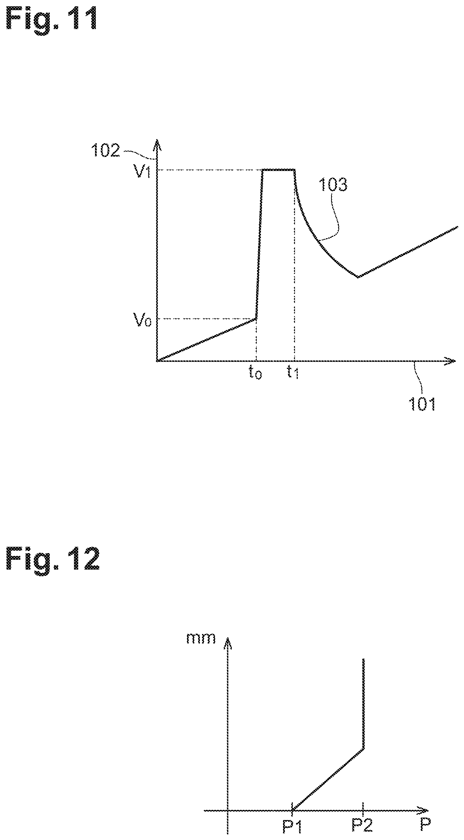

En référence à la Figure 12, il est représenté un exemple de courbe de déplacement d'une vitre d'un véhicule en réponse à une pression exercée sur un capteur élémentaire 200 utilisable dans le cadre de l'invention. Dans cet exemple, il ne se produit aucun déplacement de la vitre si l'utilisateur appuie sur l'une des zones de réglage 113a, 113b avec une pression inférieure à une première valeur seuil P1. Si l'utilisateur appuie plus fortement sur la zone de réglage 113a, 113b de telle sorte que la pression exercée soit supérieure à la première valeur seuil P1 tout en étant inférieure à une deuxième valeur seuil P2, la vitre se déplace progressivement jusqu'à atteindre sa position extrême la plus basse ou la plus haute. Dans le cas où l'utilisateur appuie fortement sur la zone de réglage 113a, 113b de telle sorte que la pression exercée soit supérieure à la deuxième valeur seuil P2, la vitre se déplace rapidement vers sa position extrême la plus basse ou la plus haute.

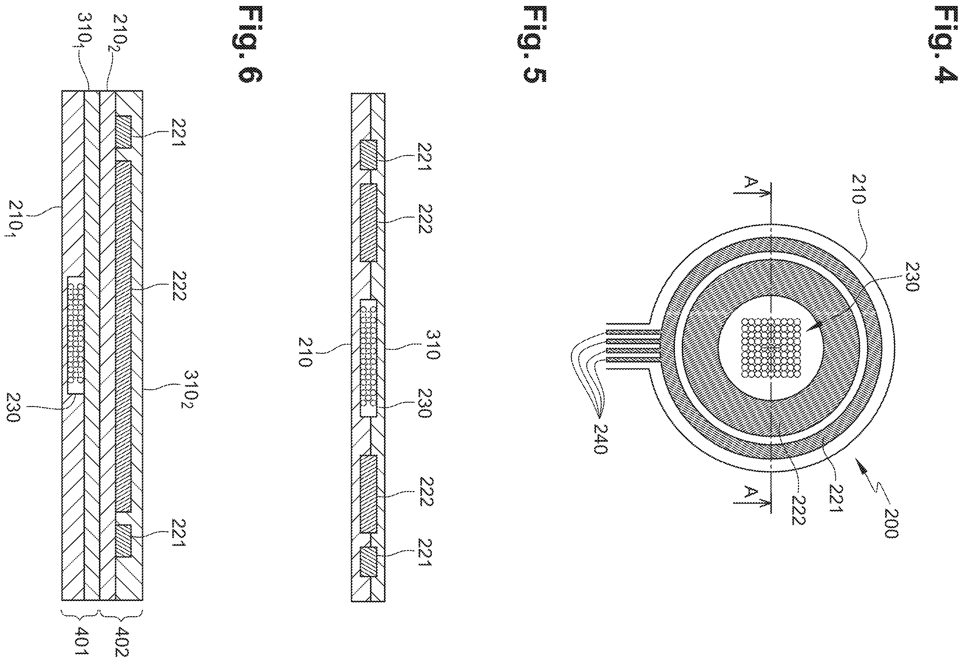

La Figure 4 représente un exemple de réalisation d'un capteur élémentaire 200 utilisable dans le boîtier de commande de l'invention. Ce capteur élémentaire 200 comprend un substrat isolant 210 sur lequel sont déposées, par des techniques connues de l'art antérieur, des pistes conductrices concentriques 221, 222 constituant un capteur capacitif.

Le substrat isolant 210 est, selon des exemples de réalisation, un polymère, par exemple un polyimide ou un PET, ou une céramique.

Lesdites pistes concentriques 221, 222 sont par exemple constituées de cuivre, d'ITO (In₂O₃ - SnO₂) pour réaliser un capteur transparent ou de tout autre matériau conducteur.

Elles sont déposées, par exemple, par photolithographie ou par lithographie douce.

Au centre du capteur est déposée une assemblée de nanoparticules constituant un capteur de force.

Selon un exemple de réalisation, adapté à la réalisation d'un capteur transparent, lesdites nanoparticules sont des nanoparticules d'ITO en suspension colloïdale dans un ligand isolant, par exemple un acide (aminométhyl) phosphonique (CH₆NO₃P).

Selon d'autres exemples de réalisation les nanoparticules sont des nanoparticules d'oxyde de zinc (ZnO) ou des nanoparticules d'or (Au).

L'assemblée de nanoparticules 230 est une assemblée monocouche ou multicouche, déposée sur le substrat, par exemple, par dépôt capillaire convectif ou par une méthode dite « d'évaporation de goutte » telle que décrite dans le document EP 2 877 911, sans que ces exemples ne soient exhaustifs ni limitatifs.

L'assemblée de nanoparticules 230 est fermement liée au substrat 210, par exemple par l'intermédiaire d'un coupleur chimique.

À titre d'exemple, le coupleur chimique est un silane (SiH4), apte à interagir avec des groupements OH de la surface du substrat préalablement activée par un traitement UV-Ozone et comportant à l'autre extrémité du coupleur un groupement carboxylique (COOH) apte à se greffer sur un groupe amine (NH2) préalablement greffé à la surface des nanoparticules.

L'assemblée de nanoparticules 230 constitue une jauge de déformation, dont la conductivité électrique varie en fonction de la distance relative entre les nanoparticules de l'assemblée.

Cette variation de conductivité ou réciproquement de résistance électrique est attribuée à la conduction par effet tunnel entre les nanoparticules, et cet effet fournit un facteur de jauge très élevé, beaucoup plus élevé que ce qu'il est possible d'obtenir avec un film piézorésistif, ce qui permet de mesurer de très faibles déformations.

À titre d'exemple, la variation proportionnelle de la résistance d'un tel capteur de force élémentaire, constitué d'une assemblée de nanoparticules d'ITO dans un ligand à base d'acide phosphonique, fait apparaître une évolution exponentielle de la réponse en fonction de la déformation subie par ledit capteur élémentaire, avec un facteur de jauge atteignant la valeur de 85 sur une plage de déformation de -1 %, en compression, à +1 % en traction pour une résistance de l'ordre de 2000.10³ Ohm en l'absence de déformation.

Ainsi ce capteur de force élémentaire est très sensible et permet de détecter une force d'appui ou de toucher, même relativement faible, appliquée audit capteur, qui peut ainsi constituer son propre corps d'épreuve. En d'autres termes, la déformation du substrat n'est pas nécessaire pour détecter un effort appliqué et l'agencement représenté Figure 4 est réalisable sur un substrat rigide tel que du dioxyde de silicium (SiO₂) ou de nitrure de silicium (Si₃N₄) tout en permettant une mesure de la force appliquée au capteur.

En référence à la Figure 11, il est représenté un exemple de variation de la tension 102 délivrée en fonction du temps 101 par un tel capteur de force élémentaire lors de l'application d'une force sur ledit capteur, par exemple un toucher. Selon cet exemple, le toucher est appliqué entre les temps t₀ et t₁. L'intensité de la force est proportionnelle à la différence V₁-V₀, dans laquelle la valeur V₁ est mesurable et la valeur V₀ dépend de facteurs environnementaux et est susceptible de varier dans le temps, notamment avec la température.

Des pistes conductrices 240, représentées ici selon une représentation de principe, également déposées sur le substrat 210, permettent l'alimentation électrique et la collecte des données du capteur capacitif et du capteur de force.

Selon un premier mode de réalisation représenté sur la Figure 5, une couche protectrice 310 est constituée d'un matériau isolant, par exemple un polyimide, ou un PET pour la réalisation d'un capteur transparent, et est déposée sur le capteur ainsi créé.

Selon ce premier mode de réalisation, le capteur élémentaire 200 combiné a un diamètre compris entre 10 mm et 30 mm et une épaisseur comprise entre 50 µm et 300 µm sans que ces valeurs ne soient limitatives.

Selon un deuxième mode de réalisation représenté sur la Figure 6, le capteur élémentaire 200 combiné est réalisé en 2 couches 401, 402, la première couche 401 comprenant, selon ce deuxième mode de réalisation, un substrat 201₁ sur lequel est déposé le capteur de force 230 selon une technologie identique à ce qui a été exposé ci-avant, et une couche 310₁ de protection, et superposée à cette première couche 401, une seconde couche 402 comprenant un substrat 210₂ sur lequel sont déposés les pistes conductrices 221, 222 réalisant le capteur capacitif.

Une couche de protection 310₂ est posée sur ledit capteur capacitif.

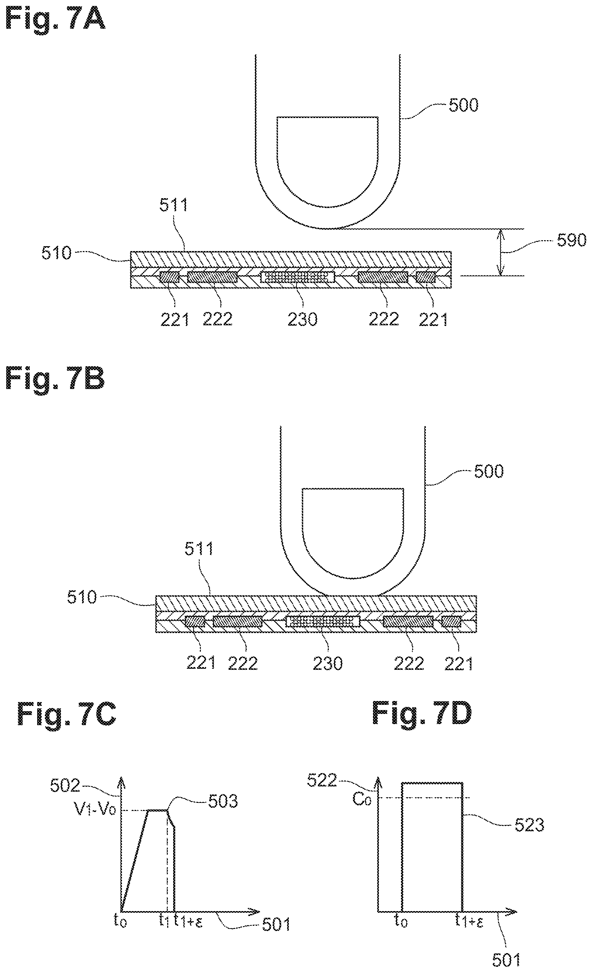

Selon un exemple de mise en œuvre représenté sur les Figures 7A et 7B, le capteur élémentaire 200 est rapporté sur une face d'un substrat 510 isolant, la face opposée 511 dudit substrat étant exposée au toucher.

Ainsi, la surface 511 de ce substrat 510 est fonctionnalisée et permet de détecter un toucher sur cette surface et de mesurer la force d'application de ce toucher.

Selon des exemples de réalisation non limitatifs, ledit substrat 510 pourra être constitué d'un polymère, de verre, de céramique, de cuir ou de bois. La sensibilité du capteur de force permet de détecter une faible déformation, et ainsi de détecter et mesurer une force de toucher même si ce substrat est relativement rigide.

Comme illustré sur la Figure 7A, lorsqu'un objet électriquement conducteur, par exemple un doigt 500, est approché de la surface 511 ainsi fonctionnalisée, à un temps t₀, sa présence est détectée, avant même qu'il n'y ait contact, dès lors que celui-ci se trouve à une distance inférieure ou égale à un distance minimale 590 du capteur capacitif.

Cette distance minimale 590 est ajustable selon les caractéristiques du capteur et un seuil défini sur le signal délivré par ledit capteur capacitif.

A titre d'exemple, la distance minimale est sélectionnée à toute valeur entre 0 et 10 mm selon l'application visée.

A cette fin, le capteur est connecté à un circuit électronique apte à réaliser ces fonctions ainsi que les étapes du procédé exposé ci-après.

Ainsi, au temps t₀, comme le montre la Figure 7D, en observant la valeur du signal 522 délivré par le capteur capacitif en fonction du temps 501, l'information 523 délivrée par ledit capteur franchit un seuil C₀ correspondant au franchissement de la distance minimale 590. Puis, dès lors que l'objet 500 entre en contact avec la surface, l'information délivrée par le capteur capacitif n'évolue plus ou très peu, même si la pression appliquée augmente.

En revenant à la Figure 11, lorsque la proximité de l'objet 500 est détectée, la valeur V₀ délivrée par le capteur de force au temps t₀ est mesurée et prise pour valeur de référence, en faisant correspondre à cette valeur une force égale à 0, puisqu'il n'y a pas contact, comme le montre la Figure 7C, qui représente la valeur 502 du signal 503 délivré par le capteur de force en fonction du temps 501, modifiée par le traitement.

Ainsi, tout phénomène de dérive de l'information délivrée par le capteur de force, notamment du fait de variations de température, est compensé.

Comme le montre la Figure 7B, lorsque l'objet 500 entre en contact avec la surface fonctionnalisée 511 et applique une force de toucher sur celle-ci, la conductivité du capteur de force est modifiée proportionnellement à la force appliquée, et celui-ci délivre, comme illustré sur la Figure 7C, une information V₁ correspondant à une force proportionnelle à V₁-V₀ , corrigée de la valeur de dérive initiale V₀ du capteur de force 230.

Lorsque la pression de toucher est relâchée au temps t₁, à bref instant (t₁+e) suivant ce relâchement, l'objet 500 se trouve à une distance de la surface 511, supérieure ou égale à la distance minimale 590, et, comme illustrée sur la Figure 7D, l'information délivrée par le capteur capacitif franchit le seuil C₀ en sens inverse.

Lorsque le franchissement de ce seuil C₀ est détecté sur le capteur capacitif, l'information délivrée par le capteur de force est considérée égale à 0. Ainsi, le retour différé à 0 de l'information délivrée par le capteur de force, du fait des phénomènes d'hystérésis, est également masqué.

Ainsi, l'utilisation combinée du capteur de force et du capteur capacitif permet de mesurer une force appliquée, et le cas échéant de déclencher des actions en fonction du niveau de cette force, en s'affranchissant des phénomènes de dérive et d'hystérésis inhérents à ce type de capteur de force et tels que représentés Figure 11.

Les Figures 7A et 7B représentent un capteur combiné selon le premier mode de réalisation représenté sur la Figure 5, l'homme du métier comprend que les mêmes principes sont applicables dans le cas d'un capteur combiné correspondant au deuxième mode de réalisation représenté sur la Figure 6.

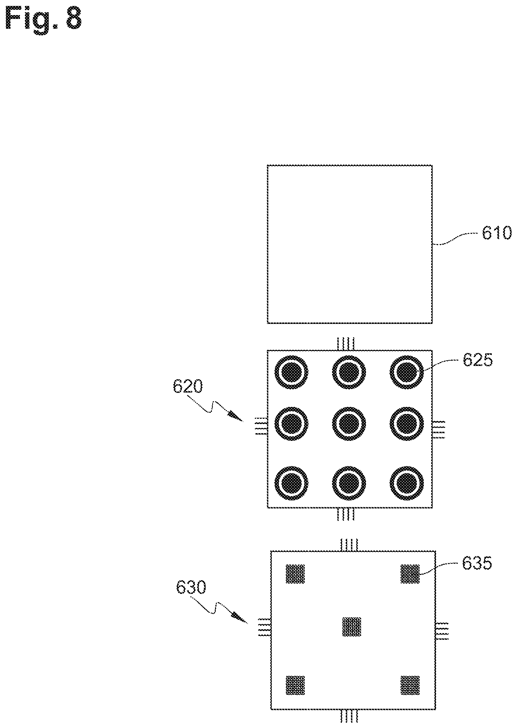

En référence à la Figure 8, une pluralité de capteurs élémentaires 200 sont associés en grille de sorte à former une surface tactile apte à détecter un toucher, sa localisation sur la grille et l'effort de pression exercé.

La Figure 8 représente un mode de réalisation combinant une pluralité de capteurs selon le mode de réalisation représenté sur la Figure 6. L'homme du métier pourra adapter ce principe au mode de réalisation du capteur élémentaire 200 représenté sur la Figure 5.

Ladite surface tactile comprend un substrat 610, constitué d'une matière électriquement isolante, et comportant une surface exposée au toucher.

Sur la face opposée à cette surface exposée au toucher du substrat 610 est rapportée une première couche 620 comprenant une grille de capteurs capacitifs 625, tels que la couche supérieure 402 de la Figure 6.

Sous la couche 620 portant la grille de capteurs capacitifs est rapportée une couche 630 comprenant une grille de capteurs de force 635 constitués d'assemblées de nanoparticules, tels que la couche inférieure 401 de la Figure 6.

Selon un premier exemple de réalisation (non représenté), le nombre de capteurs de force 635 est égal au nombre de capteurs capacitifs 625 et lesdits capteurs de force sont localisés centrés par rapport aux capteurs capacitifs.

Avantageusement, le nombre de capteurs de force 635 est réduit par rapport au nombre de capteurs capacitifs 625 et lesdits capteurs de forces sont localisés centrés, ou non, par rapport auxdits capteurs capacitifs.

Ce mode de réalisation, utilisant un nombre de capteurs de force réduit est plus économique.

En effet, quel que soit le point d'application de la force de toucher sur la surface tactile ainsi créée, l'effort de toucher est évalué, connaissant ce point d'application, et déduit des signaux délivrés par un des capteurs de force, par exemple celui le plus proche du point d'application, ou par la combinaison des informations délivrées par plusieurs de ces capteurs, au minimum 3 capteurs de force pour une surface tactile plane, selon des variantes de mise en œuvre.

La localisation du point d'application du toucher sur la surface tactile est obtenue à partir de la grille de capteurs capacitifs 625.

Ce principe reste valable en cas de points de toucher multiples.

Ce mode de réalisation permet de réaliser une surface tactile comprenant une densité élevée de capteurs capacitifs, de réalisation plus économique que les capteurs de force, et ainsi d'obtenir une localisation précise du ou des points d'application du toucher, puis d'évaluer la force appliquée lors de ces touchers par un traitement approprié des informations délivrées par un nombre réduit de capteurs de force 635 de réalisation plus coûteuse, en fonction de localisation du ou des points d'application du toucher.

Le procédé mis en œuvre reste similaire, à savoir que dès que la proximité d'un objet conducteur est détecté à une distance inférieure ou égale à la distance minimale 590 d'un des capteurs capacitifs, la valeur V₀ délivrée par chacun des capteurs de force est mesurée de sorte à recaler l'information délivrée par chacun desdits capteurs, l'effort d'application est déterminé en combinant les informations issues desdits capteurs de force en fonction de la localisation du point d'application de l'effort donné par le réseau de capteurs capacitifs, puis, lorsque l'objet s'éloigne de la surface tactile d'une distance supérieure ou égale à la distance minimale, l'effort est remis à 0.

L'homme du métier comprend que l'utilisation d'un nombre réduit de capteurs de force par rapport au nombre de capteurs capacitifs est applicable à une surface tactile de forme autre que plane, par exemple une surface en simple ou double courbure, dès lors que cette forme est stable.

Pour une surface tactile souple et de forme variable, par exemple une surface tactile appliquée sur un vêtement, le mode de réalisation comprenant un nombre de capteurs de force équivalent à celui des capteurs capacitifs et centrés par rapport à ceux-ci est préférable.

Ainsi, le dispositif tel que décrit précédemment offre dans ses variantes de réalisation des possibilités d'application très variées.

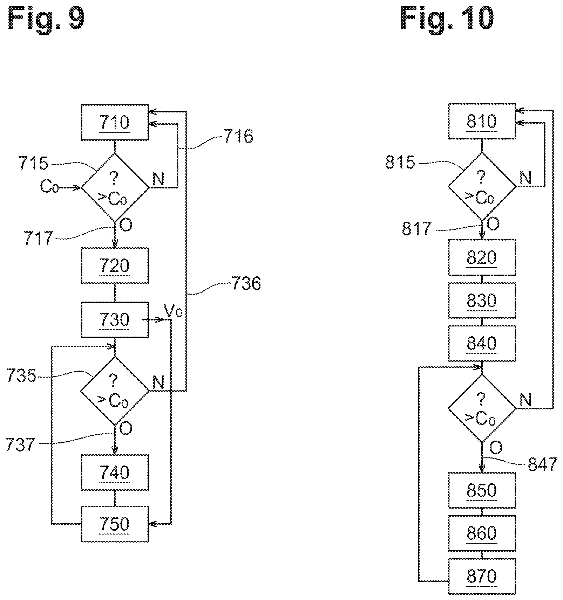

Comme illustré sur la Figure 9, la mise en œuvre d'un procédé pour la détection et la mesure de l'intensité d'une force de toucher par un objet 500 électriquement conducteur sur une surface tactile comprenant un capteur élémentaire 200 tel que décrit ci-dessus, quel que soit son mode de réalisation, comprend, selon une fréquence ou par intervalle de temps définis, la lecture 710 du signal issu du capteur capacitif et la comparaison 715 de la valeur du signal ainsi lue à une valeur définie C₀ représentative d'une distance minimale entre un objet et le capteur capacitif.

Selon cet exemple de réalisation, et en référence aux Figures 7A et 7D, lorsque cette distance est inférieure ou égale à une distance minimale, le signal délivré par le capteur capacitif est supérieur ou égal à une valeur C₀.

Dans le cas 716 où le signal délivré par le capteur capacitif reste inférieur à C₀, aucune autre action n'est déclenchée et la scrutation du signal à la fréquence ou par intervalle de temps donnés continue.

Dans le cas 717 où le signal délivré par le capteur capacitif franchit le seuil C₀ et donc qu'un objet se trouve à proximité dudit capteur, au cours d'étapes d'initialisation du capteur de force, la valeur délivrée par le capteur de force est lue 720 et au cours d'une étape de détermination de la dérive 730 la valeur ainsi lue V₀ est utilisée comme valeur de référence.

La mesure de l'effort appliqué est réalisée en regard de cette référence tant que l'objet est en contact avec la surface tactile. A cette fin le signal de sortie du capteur capacitif est comparé 735 à la valeur C₀ correspondant à la distance minimale, et tant que 737 la valeur délivrée par ce capteur reste supérieure à la valeur C₀, le signal issu du capteur de force est mesuré 740 et, au cours d'une étape de recalage 750, recalé par rapport à la valeur V₀ déterminée lors de l'étape de détermination de la dérive 730 réalisée dans la même séquence d'acquisition.

Le procédé décrit à la Figure 9 dans le cas d'un capteur élémentaire 200, s'étend au cas d'une surface tactile comprenant autant de capteurs élémentaires, avec des étapes supplémentaires consistant à localiser sur la grille de capteurs capacitifs celui où est détectée la proximité, et en fonction de cette information, appliquer les étapes de lecture de l'information délivrée 720 de mesure de dérive 730, de mesure de la force appliquée 740 et de recalage 750 au capteur de force le plus proche du capteur capacitif pour lequel la proximité du toucher est détectée.

Comme illustré sur la Figure 10, dans le cas où la surface tactile comprend une densité nettement plus importante de capteurs capacitifs comparativement au nombre de capteurs de force, au cours d'une étape 810 de scrutation, les informations délivrées par les capteurs capacitifs sont sondées à intervalle de temps régulier et l'information délivrée par chaque capteur est comparée 815 à celle, C₀, correspondant au seuil de distance minimale.

Lorsque ce seuil est dépassé 817 sur l'un des capteurs, au cours d'une étape 820 de localisation, la position du capteur capacitif activé est déterminée.

Au cours d'une étape de détermination de dérive 830 l'information délivrée par chacun des capteurs de force est lue et cette information est assignée 840 à chacun des capteurs de force respectifs comme valeur de recalage.

Tout au long du toucher 847, l'information issue des capteurs de force est acquise 850, recalée 860 pour chaque capteur par la valeur évaluée lors de l'étape 830 de détermination de dérive.

Puis, en fonction du point d'application de l'effort, déterminé lors de l'étape de localisation 820, l'effort appliqué au point considéré est estimé 870 en combinant les informations issues des capteurs de forces.

## Revendications

1. Boîtier de commande (10) pour véhicule automobile, comprenant :
- une coque externe (11) munie de plusieurs zones de commande (110), chacune des zones de commande (110) étant affectée à une fonction spécifique du véhicule automobile,
- une plaque (14) de circuit imprimé supportant une pluralité de capteurs élémentaires (200) configurés pour générer un signal électrique en réponse à une action telle qu'un mouvement d'approche, un contact ou une pression exercée par un utilisateur au moyen de ses doigts sur au moins l'une des zones de commande (110), lesdits capteurs élémentaires (200) étant reliés à une unité de commande électronique (140), le signal électrique généré par les capteurs élémentaires (200) étant transmis à l'unité de commande électronique (140) pour y être analysé et converti en une commande d'une fonction du véhicule,
chacun des capteurs élémentaires (200) comprenant au moins un substrat isolant (210) sur lequel sont déposées des pistes conductrices (221, 222) formant un capteur capacitif (625) et une assemblée (230) de nanoparticules conductrices ou semi-conductrices en suspension colloïdale dans un ligand électriquement isolant, ladite assemblée (230) formant un capteur de force (635),la pluralité de capteurs capacitifs (625) étant disposés en grille dans une première couche (620) qui est rapportée sur un substrat (610) constitué d'une matière électriquement isolante et comportant une surface exposée au toucher,
**caractérisé en ce que** la pluralité de capteurs de force (635) sont disposés en grille dans une deuxième couche (630) qui est rapportée sur ladite première couche (620), le nombre de capteurs de force (635) étant inférieur au nombre de capteurs capacitifs (625).

2. Boîtier de commande (10) selon la revendication 1, **caractérisé en ce qu'**au moins l'une des zones de commande (110) forme une protubérance, ou un creux, sur une surface supérieure de la coque externe (11) sur laquelle un doigt d'un utilisateur peut s'appuyer, ladite au moins une zone de commande (110) étant disposée de manière contiguë à l'un des capteurs élémentaires (200) de telle sorte que l'appui sur ladite au moins une zone de commande (110) génère une déformation dudit capteur élémentaire (200) qui peut être détectée par le capteur de force (230) dudit capteur élémentaire (200).

3. Boîtier de commande (10) selon la revendication 1 ou la revendication 2, **caractérisé en ce qu'**il comprend de plus une pluralité de dispositifs d'éclairage (130, 131), chacun desdits dispositifs d'éclairage (130, 131) étant aptes à émettre un faisceau de lumière en direction de la coque externe (11) au niveau d'une zone de commande (110).

4. Boîtier de commande (10) selon la revendication 3, **caractérisé en ce que** les dispositifs d'éclairage (130, 131) sont fixés sur la plaque (14) de circuit imprimé et sont disposés sous les capteurs élémentaires (200).

5. Boîtier de commande (10) selon la revendication 3 ou la revendication 4, **caractérisé en ce que** chaque dispositif d'éclairage est constitué d'une diode électroluminescente (130) et/ou d'un guide de lumière (131).

6. Boîtier de commande (10) selon l'une des revendications 3 à 5, **caractérisé en ce que** les dispositifs d'éclairage (130) sont commandés par l'unité de commande électronique (140), l'unité de commande électronique (140) pouvant faire varier le faisceau de lumière émis par les dispositifs d'éclairage (130) en fonction des signaux électriques transmis par les capteurs élémentaires (200).

7. Boîtier de commande (10) selon l'une des revendications précédentes, **caractérisé en ce que** les zones de commande (110) sont au moins de deux types, à savoir des premières zones de commande, dites zones de sélection (112a-112d ; 114a-114b), lesquelles sont destinées à sélectionner un élément spécifique du véhicule, et des deuxièmes zones de commande, dites zones de réglage (113a-113b ; 115a-115d), lesquelles sont destinées à régler soit la position, soit l'état d'un élément spécifique du véhicule préalablement sélectionné par l'une desdites zones de sélection.

8. Boîtier de commande (10) selon la revendication 7, **caractérisé en ce qu'**il comprend quatre zones de sélection (112a-112d), dites zones de sélection de vitre, affectées respectivement à la sélection d'une vitre du véhicule, respectivement une vitre avant gauche, une vitre avant droite, une vitre arrière gauche et une vitre arrière droite, et deux zones de réglage (113a, 113b), dites zones de réglage de vitre, permettant de déplacer la vitre sélectionnée par lesdites zones de sélection de vitre (112a-112d) respectivement vers le bas et vers le haut.

9. Boîtier de commande (10) selon la revendication 8, **caractérisé en ce que** des capteurs élémentaires (200) disposés sous les zones de sélection de vitre (112a-112d) sont configurés pour détecter le contact d'un doigt d'un utilisateur sur lesdites zones de sélection de vitre (112a-112d) au moyen de leur capteur capacitif (221, 222) et **en ce que** des capteurs élémentaires (200) disposés sous les zones de réglage de vitre (113a, 113b) sont configurés pour détecter la pression d'un doigt d'un utilisateur sur lesdites zones de réglage de vitre (113a, 113b) au moyen de leur capteur de force (230).

10. Boîtier de commande (10) selon la revendication 7 ou 8, **caractérisé en ce que** les capteurs élémentaires (200) sont imprimés sur un film inséré entre la coque externe (11) et les dispositifs d'éclairage (130, 131) présents sur la face supérieure de la plaque (14) de circuit imprimé.

11. Boîtier de commande (10) selon l'une des revendication 7 à 9, **caractérisé en ce qu'**il comprend deux zones de sélection (114a, 114b), dites zones de sélection de rétroviseur, affectées respectivement à la sélection d'un rétroviseur du véhicule, respectivement un rétroviseur latéral gauche et un rétroviseur latéral droit, et quatre zones de réglage (115a-115d), dites zones de réglage de rétroviseur, permettant de déplacer le rétroviseur sélectionné par lesdites zones de sélection de rétroviseur (114a, 114b) respectivement vers la gauche, vers la droite, vers le bas et vers le haut.

12. Boîtier de commande (10) selon la revendication 11, **caractérisé en ce que** des capteurs élémentaires (200) disposés sous les zones de sélection de rétroviseur (114a, 114b) et sous les zones de réglage de rétroviseur (115a, 115d) sont configurés pour détecter le contact d'un doigt d'un utilisateur respectivement sur lesdites zones de sélection de rétroviseur (114a, 114b) et sur lesdites zones de réglage de rétroviseur (115a-115d) au moyen de leur capteur capacitif (221, 222).

13. Boîtier de commande (10) selon l'une des revendications précédentes, **caractérisé en ce qu'**il comprend deux zones de commande (111a, 111b), dites zones de verrouillage/déverrouillage, permettant respectivement de verrouiller et de déverrouiller les portes du véhicule.

14. Boîtier de commande (10) selon l'une des revendications précédentes, **caractérisé en ce qu'**il comprend au moins un capteur élémentaire (200) configuré pour détecter la présence d'un doigt d'un utilisateur à proximité du boîtier de commande (10) au moyen de son capteur capacitif (221, 222), l'unité de commande électronique (140) étant apte, en réponse au signal transmis par ledit au moins un capteur élémentaire (200), de faire passer au moins certains des capteurs élémentaires (200) d'un mode désactivé, dans lequel ils ne sont pas sensibles aux actions d'un utilisateur, à un mode activé, dans lequel ils sont sensibles aux actions d'un utilisateur.

15. Boîtier de commande (10) selon l'une des revendications précédentes, **caractérisé en ce qu'**il comprend au moins un capteur élémentaire (200) configuré pour détecter le contact d'un doigt d'un utilisateur sur une zone de commande (110) spécifique du boîtier de commande (10) au moyen de son capteur capacitif (221, 222), l'unité de commande électronique (140) étant apte, en réponse au signal transmis par ledit au moins un capteur élémentaire (200), de faire passer certains des capteurs élémentaires (200) d'un mode partiellement activé, dans lequel ils peuvent uniquement détecter le contact d'un doigt d'un utilisateur au moyen de leur capteur capacitif (221, 222), à un mode désactivé, dans lequel ils ne sont pas sensibles aux actions d'un utilisateur, et certains autres capteurs élémentaires (200) d'un mode désactivé, dans lequel ils ne sont pas sensibles aux actions d'un utilisateur, à un mode partiellement activé, dans lequel ils peuvent uniquement détecter la pression d'un doigt d'un utilisateur au moyen de leur capteur de force (230).

16. Véhicule automobile comprenant un boîtier de commande (10) selon l'une des revendications précédentes.

## Patentansprüche

1. Steuergehäuse (10) für Kraftfahrzeuge, umfassend:
- eine Außenschale (11), die mit mehreren Steuerbereichen (110) versehen ist, wobei jeder der Steuerbereiche (110) einer spezifischen Funktion des Kraftfahrzeugs zugeordnet ist,
- eine Leiterplatte (14), die eine Vielzahl von Elementarsensoren (200) trägt, die so konfiguriert sind, dass sie ein elektrisches Signal als Reaktion auf eine Aktion wie eine Annäherungsbewegung, einen Kontakt oder einen Druck, der von einem Benutzer mittels seiner Finger auf mindestens einen der Steuerbereiche (110) ausgeübt wird, erzeugen, wobei die Elementarsensoren (200) mit einer elektronischen Steuereinheit (140) verbunden sind, wobei das von den Elementarsensoren (200) erzeugte elektrische Signal an die elektronische Steuereinheit (140) übertragen wird, um dort ausgewertet und in eine Steuerung einer Fahrzeugfunktion umgewandelt zu werden, wobei jeder der Elementarsensoren (200) mindestens ein isolierendes Substrat (210) umfasst, auf dem Leiterbahnen (221, 222) aufgebracht sind, die einen kapazitiven Sensor (625) bilden, und eine Baugruppe (230) von leitenden oder halbleitenden Nanopartikeln in kolloidaler Suspension in einem elektrisch isolierenden Liganden, wobei die Baugruppe (230) einen Kraftsensor (635) bildet, wobei die Vielzahl von kapazitiven Sensoren (625) in einem Gitter in einer ersten Schicht (620) angeordnet sind, die auf einem Substrat (610) aufgebracht ist, das aus einem elektrisch isolierenden Material besteht und eine berührbare Oberfläche aufweist,
**dadurch gekennzeichnet, dass** die Vielzahl von Kraftsensoren (635) in einem Gitter in einer zweiten Schicht (630) angeordnet sind, die auf die erste Schicht (620) aufgebracht ist, wobei die Anzahl der Kraftsensoren (635) geringer ist als die Anzahl der kapazitiven Sensoren (625).

2. Steuergehäuse (10) nach Anspruch 1, **dadurch gekennzeichnet, dass** mindestens einer der Steuerbereiche (110) eine Erhebung oder Vertiefung auf einer oberen Oberfläche der Außenschale (11) bildet, auf die sich ein Finger eines Benutzers abstützen kann, wobei der mindestens eine Steuerbereich (110) benachbart zu einem der Elementarsensoren (200) angeordnet ist, so dass das Abstützen auf den mindestens einen Steuerbereich (110) eine Verformung des Elementarsensors (200) erzeugt, die von dem Kraftsensor (230) des Elementarsensors (200) detektiert werden kann.

3. Steuergehäuse (10) nach Anspruch 1 oder Anspruch 2, **dadurch gekennzeichnet, dass** es ferner eine Vielzahl von Beleuchtungsvorrichtungen (130, 131) umfasst, wobei jede der Beleuchtungsvorrichtungen (130, 131) in der Lage ist, einen Lichtstrahl in Richtung der Außenschale (11) in Höhe eines Steuerbereichs (110) auszusenden.

4. Steuergehäuse (10) nach Anspruch 3, **dadurch gekennzeichnet, dass** die Beleuchtungsvorrichtungen (130, 131) auf der Leiterplatte (14) befestigt und unter den Elementarsensoren (200) angeordnet sind.

5. Steuergehäuse (10) nach Anspruch 3 oder Anspruch 4, **dadurch gekennzeichnet, dass** jede Beleuchtungsvorrichtung aus einer Leuchtdiode (130) und/oder einem Lichtleiter (131) besteht.

6. Steuergehäuse (10) nach einem der Ansprüche 3 bis 5, **dadurch gekennzeichnet, dass** die Beleuchtungsvorrichtungen (130) von der elektronischen Steuereinheit (140) gesteuert werden, wobei die elektronische Steuereinheit (140) den von den Beleuchtungsvorrichtungen (130) ausgestrahlten Lichtstrahl in Abhängigkeit von den von den Elementarsensoren (200) übertragenen elektrischen Signalen variieren kann.

7. Steuergehäuse (10) nach einem der vorhergehenden Ansprüche, **dadurch gekennzeichnet, dass** die Steuerbereiche (110) mindestens zwei Typen sind, nämlich erste Steuerbereiche, Auswahlbereiche (112a-112d; 114a-114b), die dazu bestimmt sind, ein spezifisches Element des Fahrzeugs auszuwählen, und zweite Steuerbereiche, Einstellbereiche (113a-113b; 115a-115d), die dazu bestimmt sind, entweder die Position oder den Zustand eines bestimmten Elements des Fahrzeugs einzustellen, das zuvor durch einen der Auswahlbereiche ausgewählt wurde.

8. Steuergehäuse (10) nach Anspruch 7, **dadurch gekennzeichnet, dass** es vier Auswahlbereiche (112a-112d), Fensterauswahlbereiche, die jeweils der Auswahl eines Fensters des Fahrzeugs zugeordnet sind, jeweils ein vorderes linkes Fenster, ein vorderes rechtes Fenster, ein hinteres linkes Fenster und ein hinteres rechtes Fenster, sowie zwei Einstellbereiche (113a, 113b), Fenstereinstellbereiche, umfasst, die es ermöglichen, das durch die Fensterauswahlbereiche (112a-112d) ausgewählte Fenster jeweils nach unten und nach oben zu bewegen.

9. Steuergehäuse (10) nach Anspruch 8, **dadurch gekennzeichnet, dass** unter den Fensterauswahlbereichen (112a-112d) angeordnete Elementarsensoren (200) so konfiguriert sind, dass sie mittels ihres kapazitiven Sensors (221, 222) das Berühren der Fensterauswahlbereiche (112a-112d) mit einem Finger eines Benutzers detektieren, und dass unter den Fenstereinstellbereichen (113a, 113b) angeordnete Elementarsensoren (200) so konfiguriert sind, dass sie mittels ihres Kraftsensors (230) das Drücken auf die Fenstereinstellbereiche (113a, 113b) mit einem Finger eines Benutzer detektieren.

10. Steuergehäuse (10) nach Anspruch 7 oder 8, **dadurch gekennzeichnet, dass** die Elementarsensoren (200) auf eine zwischen der Außenschale (11) und den auf der Oberseite der Leiterplatte (14) vorhandenen Beleuchtungsvorrichtungen (130, 131) eingefügte Folie gedruckt sind.

11. Steuergehäuse (10) nach einem der Ansprüche 7 bis 9, **dadurch gekennzeichnet, dass** es zwei Auswahlbereiche (114a, 114b), Spiegelauswahlbereiche, die jeweils der Auswahl eines Spiegels des Fahrzeugs zugeordnet sind, jeweils einem linken Seitenspiegel und einem rechten Seitenspiegel, und vier Einstellbereiche (115a-115d), Spiegeleinstellbereiche, umfasst, die es ermöglichen, den durch die Spiegelauswahlbereiche (114a, 114b) ausgewählten Spiegel jeweils nach links, nach rechts, nach unten und nach oben zu verschieben.

12. Steuergehäuse (10) nach Anspruch 11, **dadurch gekennzeichnet, dass** unter den Spiegelauswahlbereichen (114a, 114b) und unter den Spiegeleinstellbereichen (115a, 115d) angeordnete Elementarsensoren (200) so konfiguriert sind, dass sie mittels ihres kapazitiven Sensors (221, 222) das Berühren der Spiegelauswahlbereiche (114a, 114b) und der Spiegeleinstellbereiche (115a-115d) mit einem Finger eines Benutzers detektieren.

13. Steuergehäuse (10) nach einem der vorhergehenden Ansprüche, **dadurch gekennzeichnet, dass** es zwei Steuerbereiche (111a, 111b), Verriegelungs-/Entriegelungsbereiche, umfasst, die jeweils das Verriegeln und das Entriegeln der Türen des Fahrzeugs ermöglichen.

14. Steuergehäuse (10) nach einem der vorhergehenden Ansprüche, **dadurch gekennzeichnet, dass** es mindestens einen Elementarsensor (200) umfasst, der so konfiguriert ist, dass er die Anwesenheit eines Fingers eines Benutzers in der Nähe des Steuergehäuses (10) mittels seines kapazitiven Sensors (221, 222) detektiert, wobei die elektronische Steuereinheit (140) in der Lage ist, als Reaktion auf das von dem mindestens einen Elementarsensor (200) übertragene Signal mindestens einige der Elementarsensoren (200) von einem deaktivierten Modus, in dem sie nicht auf Aktionen eines Benutzers reagieren, in einen aktivierten Modus, in dem sie auf Benutzeraktionen reagieren, zu versetzen.

15. Steuergehäuse (10) nach einem der vorhergehenden Ansprüche, **dadurch gekennzeichnet, dass** es mindestens einen Elementarsensor (200) umfasst, der so konfiguriert ist, dass er mittels seines kapazitiven Sensors (221, 222) das Berühren eines spezifischen Steuerbereichs (110) des Steuergehäuses (10) mit einem Finger eines Benutzers detektiert, wobei die elektronische Steuereinheit (140) in der Lage ist, als Reaktion auf das von dem mindestens einen Elementarsensor (200) übertragene Signal einige der Elementarsensoren (200) von einem teilweise aktivierten Modus, in dem sie nur das Berühren mit einem Finger eines Benutzers mittels ihres kapazitiven Sensors (221, 222) detektieren können, in einen deaktivierten Modus, in dem sie nicht auf Aktionen eines Benutzers reagieren, und einige andere Elementarsensoren (200) von einem deaktivierten Modus, in dem sie nicht auf Aktionen eines Benutzers reagieren, in einen teilweise aktivierten Modus, in dem sie nur den Druck eines Fingers eines Benutzers mittels ihres Kraftsensors (230) detektieren können, zu versetzen.

16. Kraftfahrzeug, das ein Steuergehäuse (10) nach einem der vorhergehenden Ansprüche umfasst.

## Claims

1. A control case (10) for a motor vehicle, comprising:
- an outer shell (11) provided with several control areas (110), each of the control areas (110) being assigned to a specific function of the motor vehicle,
- a printed circuit board (14) supporting a plurality of elementary sensors (200) configured to generate an electrical signal in response to an action such as an approach movement, a contact or a pressure exerted by a user by means of his fingers on at least one of the control areas (110), said elementary sensors (200) being connected to an electronic control unit (140), the electric signal generated by the elementary sensors (200) being transmitted to the electronic control unit (140) in order to be analyzed therein and converted into a control of a function of the vehicle,
each of the elementary sensors (200) comprising at least one insulating substrate (210) on which are deposited conductive tracks (221, 222) forming a capacitive sensor (625) and an assembly (230) of conductive or semi-conductive nanoparticles in colloidal suspension in an electrically insulating ligand, said assembly (230) forming a force sensor (635), the plurality of capacitive sensors (625) being disposed in a grid into a first layer (620) that is attached to a substrate (610) made of an electrically insulating material and including a surface exposed to the touch, **characterized in that** the plurality of force sensors (635) being disposed in a grid into a second layer (630) that is attached to said first layer (620), the number of force sensors (635) being less than the number of capacitive sensors (625).

2. The control case (10) according to claim 1, **characterized in that** at least one of the control areas (110) forms a protuberance, or a recess, on an upper surface of the outer shell (11) on which a user's finger can press, said at least one control area (110) being disposed contiguously with one of the elementary sensors (200) such that pressing said at least one control area (110) generates a deformation of said elementary sensor (200) which may be detected by the force sensor (230) of said elementary sensor (200).

3. The control case (10) according to claim 1 or claim 2, **characterized in that** it further comprises a plurality of lighting devices (130, 131), each of said lighting devices (130, 131) being capable of emitting a beam of light in the direction of the outer shell (11) at the level of a control area (110).

4. The control case (10) according to claim 3, **characterized in that** the lighting devices (130, 131) are fastened on the printed circuit board (14) and are disposed under the elementary sensors (200).

5. The control case (10) according to claim 3 or claim 4, **characterized in that** each lighting device consists of a light emitting diode (130) and/or a light guide (131).

6. The control case (10) according to any of claims 3 to 5, **characterized in that** the lighting devices (130) are controlled by the electronic control unit (140), the electronic control unit (140) being able to vary the beam of light emitted by the lighting devices (130) according to the electrical signals transmitted by the elementary sensors (200).

7. The control case (10) according to any of the preceding claims, **characterized in that** the control areas (110) are at least of two types, namely first control areas, called selection areas (112a-112d; 114a-114b), which are intended to select a specific element of the vehicle, and second control areas, called adjustment areas (113a-113b; 115a-115d), which are intended to adjust either the position or the state of a specific element of the vehicle previously selected by one of said selection areas.

8. The control case (10) according to claim 7, **characterized in that** it comprises four selection areas (112a-112d), called window selection areas, respectively assigned to the selection of a vehicle window, respectively a left front window, a right front window, a left rear window and a right rear window, and two adjustment areas (113a, 113b), called window adjustment areas, making it possible to displace the window selected by said window selection areas (112a-112d) downwards and upwards respectively.

9. The control case (10) according to claim 8, **characterized in that** elementary sensors (200) disposed under the window selection areas (112a-112d) are configured to detect the contact of a finger of a user on said window selection areas (112a-112d) by means of their capacitive sensor (221, 222) and **in that** elementary sensors (200) disposed under the window adjustment areas (113a, 113b) are configured to detect the pressure of a user's finger on said window adjustment areas (113a, 113b) by means of their force sensor (230).

10. The control case (10) according to claim 7 or 8, **characterized in that** the elementary sensors (200) are printed on a film inserted between the outer shell (11) and the lighting devices (130, 131) present on the upper side of the printed circuit board (14).

11. The control case (10) according to any of claims 7 to 9, **characterized in that** it comprises two selection areas (114a, 114b), called mirror selection areas, respectively assigned to the selection of a mirror of the vehicle, respectively a left side mirror and a right side mirror, and four adjustment areas (115a-115d), called mirror adjustment areas, making it possible to displace the mirror selected by said mirror selection areas (114a, 114b ) respectively to the left, to the right, downwards and upwards.

12. The control case (10) according to claim 11, **characterized in that** elementary sensors (200) disposed under the mirror selection areas (114a, 114b) and under the mirror adjustment areas (115a, 115d) are configured to detect the contact of a finger of a user respectively on said mirror selection areas (114a, 114b) and on said mirror adjustment areas (115a-115d) by means of their capacitive sensor (221, 222).

13. The control case (10) according to any of the preceding claims, **characterized in that** it comprises two control areas (111a, 111b), called locking/unlocking areas, making it possible to respectively lock and unlock the doors of the vehicle.

14. The control case (10) according to any of the preceding claims, **characterized in that** it comprises at least one elementary sensor (200) configured to detect the presence of a finger of a user near the control case (10) by means of its capacitive sensor (221, 222), the electronic control unit (140) being capable, in response to the signal transmitted by said at least one elementary sensor (200), of switching at least some of the elementary sensors (200) from a deactivated mode, in which they are not sensitive to the actions of a user, to an activated mode, in which they are sensitive to the actions of a user.

15. The control case (10) according to any of the preceding claims, **characterized in that** it comprises at least one elementary sensor (200) configured to detect the contact of a finger of a user on a control area (110) specific to the control case (10) by means of its capacitive sensor (221, 222), the electronic control unit (140) being capable, in response to the signal transmitted by said at least one elementary sensor (200), to switch some of the elementary sensors (200) from a partially activated mode, in which they can only detect the contact of a finger of a user by means of their capacitive sensor (221, 222), to a deactivated mode, in which they are not sensitive to the actions of a user, and some other elementary sensors (200) from a deactivated mode, in which they are not sensitive to the actions of a user, to a partially activated mode, in which they may only detect the pressure of a finger from a user by means of their force sensor (230).

16. A motor vehicle comprising a control case (10) according to any of the preceding claims.
